# EUROPEAN PATENT SPECIFICATION

(11) **EP 4 312 234 B1**
(45) Date of publication and mention of the grant of the patent: **25.02.2026**
(21) Application number: 23185523.0
(22) Date of filing: 14.07.2023
(51) Int. Cl.: H10D 1/00, H01L 23/522, H01F 17/00, H10D 1/20

(54) **8-SHAPED INDUCTOR WITH GROUND BAR STRUCTURE**
8-FÖRMIGE INDUKTIVITÄT MIT MASSESCHIENENSTRUKTUR
INDUCTEUR EN FORME DE 8 AVEC STRUCTURE DE BARRE DE MASSE

(30) Priority: 28.07.2022 US 202263369666 P; 03.07.2023 US 202318218003
(43) Date of publication of application: 31.01.2024
(73) Proprietor: MEDIATEK INC., Hsin-Chu 300 (TW)
(72) Inventor: HUNG, Hsin-Yu, 30078 Hsinchu City (TW); SUN, Ruey-Bo, 30078 Hsinchu City (TW); LIN, Sheng-Mou, 30078 Hsinchu City (TW)
(74) Representative: Hoefer & Partner Patentanwälte mbB

(56) References cited:
- EP-B1- 2 266 121
- US-A1- 2020 336 160
- US-B1- 10 749 468
- US-B1- 9 948 313

## Description

### Background

This invention relates to integrated circuit inductors, and more particularly to an on-die, 8-shaped inductor with ground bar structure capable for mitigating inductor coupling. In particular, the present invention relates to a semiconductor device according to the precharacterizing part of independent claim 1. Such a semiconductor device is described in EP 2 266 121 B1. Further semiconductor devices are described in US 10 749 468 B1, US 2020/336160 A1, and US 9 948 313 B1.

Inductance-capacitance phase-locked loop (LC-PLL) circuits are used in both wireless and wireline communication systems, as well as other applications and environments. The integrated inductor of the LC tank in a voltage-controlled oscillator (VOC) plays a key role for the overall circuit performance, especially affecting phase noise significantly.

It is known that insufficient isolation between different inductors of LC-PLL circuits may degrade the phase noise suppression performance of an oscillator in a silicon die due to inductor coupling effects. There is a need in this technical field to reduce the inductor coupling between inductors on a silicon die.

### Summary

It is one object of the present disclosure to provide an improved integrated inductor for mitigating inductor noise coupling and a device using the same. A semiconductor device according to the invention is defined in independent claim 1. The dependent claims define preferred embodiments thereof.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 shows an exemplary semiconductor device in accordance with an embodiment of the invention;
FIG. 2 is a schematic diagram showing a semiconductor device according to another embodiment of the invention;
FIG. 3 is a schematic diagram showing a semiconductor device according to still another embodiment of the invention; and
FIG. 4 is an experimental plot showing the isolation enhancement of the semiconductor device.

### Detailed Description

In the following detailed description of embodiments of the invention, reference is made to the accompanying drawings, which form a part hereof, and in which is shown by way of illustration specific preferred embodiments in which the disclosure may be practiced.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

As the integration surface on silicon is getting smaller and smaller, interactions among sensitive blocks and electromagnetic (EM) sources (like voltage controlled oscillators or VOCs) become stronger. The voltage controlled oscillator performance governs many aspects of the performance of the whole phase locked loop or frequency synthesizer. An inductor-capacitor voltage-controlled oscillator (LC-VOC) is comprised of a negative gm cell, a switched capacitor array (SCA), an inductor, and so on. 8-shaped inductors are used in the inductor-capacitor voltage-controlled oscillator.

However, the noise coupling has become an issue for such 8-shaped inductor. Insufficient isolation between inductors in LC-PLL circuits may degrade the phase noise suppression performance of an oscillator in a silicon die due to inductor coupling effects.

The present disclosure provides a semiconductor device comprising an 8-shaped inductor for on-die inductor coupling mitigation in order to address this problem. A better electrical performance can be obtained in a case that the inductor according to the present disclosure is used in, for example a voltage-controlled oscillator. According to the experimental results, at least 15dB coupled noise reduction can be observed at the inductor of a victim circuit.

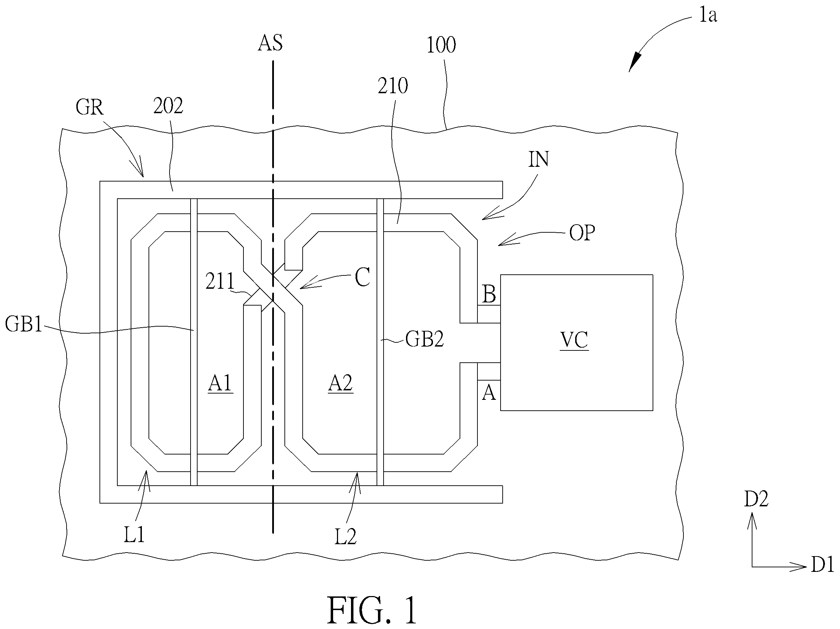

FIG. 1 shows a semiconductor device 1a in accordance with an embodiment of the invention. As shown in FIG. 1, a semiconductor device 1a comprises a substrate 100 such as a silicon-based substrate and an inductor IN fabricated on the substrate 100. The inductor IN is at least partially surrounded by a ground ring GR. Preferably, for example, the ground ring GR may be constructed at top metal layers 202 over the substrate 100. The top metal layer mentioned herein is not limited to the topmost metal layer. For example, the top metal layers may comprise the topmost metal layer and several upper metal layers below the topmost metal layer. It is to be understood that the ground ring GR may be defined in any of the top metal layers.

Preferably, for example, the top metal layer 202 may be an aluminum layer, but is not limited thereto. The inductor IN is formed by using a conductor 210 that is arranged between two terminals A, B of a circuit VC, for example, a victim circuit that is disposed adjacent to an opened end OP of the ground ring GR. Although an open-loop type ground ring GR is illustrated, it is to be understood that in some embodiments the ground ring GR may be a close-loop type ground ring. Preferably, for example, the circuit VC may be a switched capacitor array of an inductor-capacitor voltage-controlled oscillator, but is not limited thereto.

The conductor 210 is shaped for forming a first loop L1 and a second loop L2 of the single-turn inductor IN. The first loop L1 and the second loop L2 are arranged side-by-side along a first direction D1. A crossing C is present between the first loop L1 and the second loop L2. When viewed from the above, the first loop L1 encloses a first area A1 and the second loop L2 encloses a second area A2. The first loop L1 is defined by the conductor 210 and the crossing C, which makes the first area A1, at least in projection in a direction perpendicular to the plane in which the first loop is arranged, fully enclosed. The second loop L2 is defined by the conductor 210 and the crossing C. Preferably, the second area A2 is not fully enclosed.

Preferably, the first loop L1 may be asymmetric to the second loop L2 with respect to the axis AS, and the first area A1 may be smaller than the second area A2. In this case, the second loop L2 with larger surface area is disposed closer to the circuit VC and the first loop L1 is disposed farther away from the circuit VC. Preferably, the first loop L1 may be symmetric to the second loop L2 with respect to the axis AS. It is not intended to limit the size of the two loops. In some embodiments, the first loop L1 may be greater than the second loop L2, depending on the design requirements of the figure-eight inductor.

The inductor IN may be fabricated on the substrate 100 by conventional semiconductor fabrication processes including but not limited to deposition, lithography, etching, cleaning, polishing, annealing or the like. The inductor IN may be composed of at least two interconnect layers. Generally, the thicker top interconnect layer has lower resistance and the inductor IN is generally laid out in the top metal layers, except for the locations where the conductor 210 crosses itself. At those crossings the lower interconnect layer may be used. For example, in FIG. 1, the conductor 210 may be located in the top metal layers and connected to an underlying interconnect layer 211 at the crossing C. The interconnect layer 211 may be located in the lower metal layer.

Preferably, the inductor IN further comprises a first ground bar GB1 traversing the first loop L1 and a second ground bar GB2 traversing the second loop L2. The first ground bar GB1 and the second ground bar GB2 extend along a second direction D2 The second direction D2 is orthogonal to the first direction D1. Preferably, for example, the first ground bar GB1 may pass through the center of the first loop L1 and the second ground bar GB2 may pass through the center of the second loop L2. Optionally, one of the first ground bar GB1 and the second ground bar GB2 may be omitted. The inductor IN may comprise at least one ground bar passing through a center of either of the first loop L1 or the second loop L2.

Preferably, for example, the first ground bar GB1 and the second ground bar GB2 may be fabricated with a minimum design rule or may have a width or dimension that substantially equals to the minimum line width of metal interconnection layer or the interconnection process limits, which may vary with different processes. In some embodiments, the first ground bar GB1 and the second ground bar GB2 may have various widths, but not limited to the minimum design rule, as long as their sizes do not exceed the loop size. The width or dimension of the first ground bar GB1 and the second ground bar GB2 is a tradeoff between inductor performance and inductor-inductor spur level. The first ground bar GB1 and the second ground bar GB2 are electrically connected to the ground ring GR. The first ground bar GB1 and the second ground bar GB2 are not electrically connected to the conductor 210 or the interconnect layer 211. The first ground bar GB1 and the second ground bar GB2 may be fabricated at a metal layer that is different from the conductor 210. According to an exemplary embodiment, as shown in FIG. 1, the first ground bar GB1 and the second ground bar GB2 are disposed at a metal layer that is higher than the conductor 210. However, it is to be understood that the first ground bar GB1 and the second ground bar GB2 may be fabricated at a metal layer that is lower than the conductor 210 in some cases. In operation, the first ground bar GB1 and the second ground bar GB2 are grounded, which can effectively reduce the inductor coupling effect.

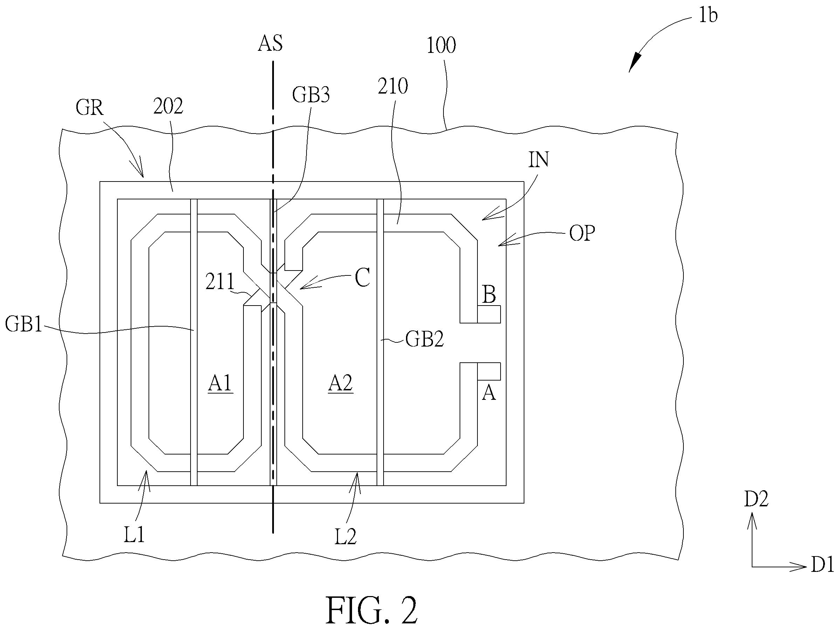

FIG. 2 is a schematic diagram showing a semiconductor device 1b according to another embodiment of the invention, wherein like regions, layers or elements are designated by like numeral numbers or labels. As shown in FIG. 2, the inductor IN of the semiconductor device 1b may further comprise a third ground bar GB3 interposed between the first ground bar GB1 and the second ground bar GB2. When viewed from the above, the third ground bar GB3 may overlap with the crossing C. Preferably, the third ground bar GB3 may pass through the center of the inductor IN. Preferably, the third ground bar GB3 may extend along the second direction D2 and in parallel with the first ground bar GB1 and the second ground bar GB2.

Likewise, the third ground bar GB3 may be fabricated with a minimum design rule or may have a width or dimension that substantially equals to the minimum line width of metal interconnection layer or the interconnection process limits, which may vary with different processes. Preferably, the third ground bar GB3 is also electrically connected to the ground ring GR. The third ground bar GB3 is not electrically connected to the conductor 210 or the interconnect layer 211. The third ground bar GB3 is fabricated at a metal layer that is different from the conductor 210 or the interconnect layer 211. Preferably, the first ground bar GB1, the second ground bar GB2, and the third ground bar GB3 may be fabricated at the same metal layer.

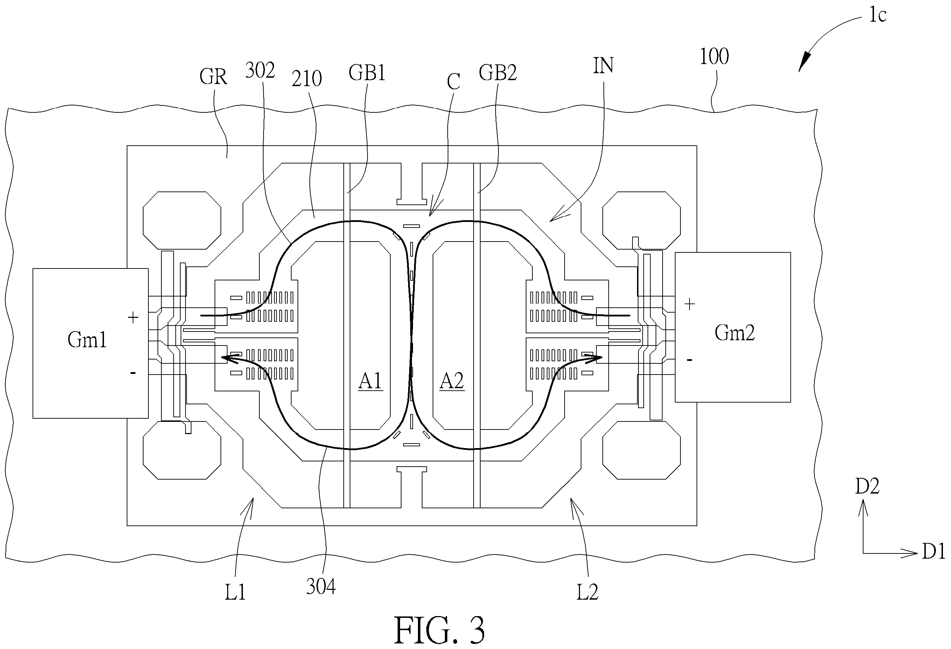

FIG. 3 is a schematic diagram showing a semiconductor device 1c according to still another embodiment of the invention, wherein like regions, layers or elements are designated by like numeral numbers or labels. The semiconductor device 1c may be a dual core oscillator. As shown in FIG. 3, the semiconductor device 1c comprises a substrate 100 such as a silicon-based substrate and an inductor IN fabricated on the substrate 100. The inductor IN is at least partially surrounded by a ground ring GR. Preferably, for example, the ground ring GR may be constructed at top metal layers 202 over the substrate 100. The inductor IN is formed by using a conductor 210 that is arranged between terminals of circuits such as gm cells Gm1 and Gm2. The 8-shaped current flow of the semiconductor device 1c is indicated by arrows 302 and 304. The current 302 flows from the positive terminal of the gm cell Gm1 to the negative terminal of the gm cell Gm2. The current 302 flows from the positive terminal of the gm cell Gm2 to the negative terminal of the gm cell Gm1.

Preferably, the conductor 210 is shaped for forming a first loop L1 and a second loop L2 of the single-turn inductor IN. The first loop L1 and the second loop L2 are arranged side-by-side along a first direction D1. A crossing C is present between the first loop L1 and the second loop L2. When viewed from the above, the first loop L1 encloses a first area A1 and the second loop L2 encloses a second area A2.

Preferably, the inductor IN further comprises a first ground bar GB1 traversing the first loop L1 and a second ground bar GB2 traversing the second loop L2. The first ground bar GB1 and the second ground bar GB2 extend along a second direction D2 The second direction D2 is orthogonal to the first direction D1. Preferably, for example, the first ground bar GB1 may pass through the center of the first loop L1 and the second ground bar GB2 may pass through the center of the second loop L2. Optionally, one of the first ground bar GB1 and the second ground bar GB2 may be omitted.

Preferably, the first ground bar GB1 and the second ground bar GB2 may be fabricated with a minimum design rule or may have a width or dimension that substantially equals to the minimum line width of metal interconnection layer or the interconnection process limits, which may vary with different processes. Preferably, the first ground bar GB1 and the second ground bar GB2 are electrically connected to the ground ring GR. The first ground bar GB1 and the second ground bar GB2 are not electrically connected to the conductor 210. The first ground bar GB1 and the second ground bar GB2 may be fabricated at a metal layer that is different from the conductor 210.

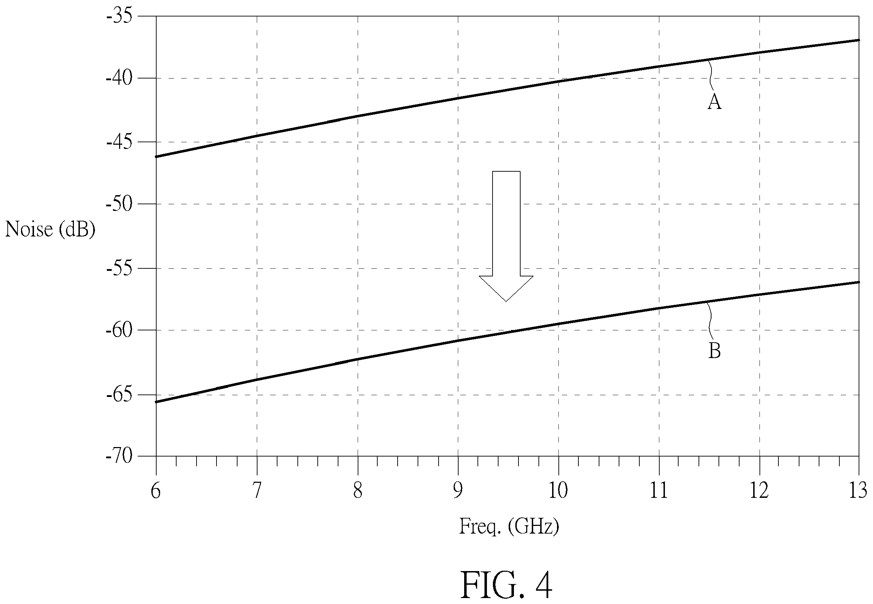

In operation, the first ground bar GB1 and the second ground bar GB2 are grounded, which can effectively reduce the inductor coupling effect. FIG. 4 is an experimental plot showing the isolation enhancement of the semiconductor device. In FIG. 4, curve A represents the noise versus frequency trend of inductor coupling based on prior art design and curve B represents the noise versus frequency trend of inductor coupling based on the present invention. As shown in FIG. 4, over 15dB coupled noise reduction can be achieved.

## Claims

1. A semiconductor device (1a; 1b; 1c), comprising:
a substrate (100);
a first terminal (A) and a second terminal (B);
a conductor (210) arranged on the substrate (100) between the first terminal (A) and the second terminal (B) to constitute an inductor (IN) shaped for forming a first loop (L1) and a second loop (L2) arranged side-by-side along a first direction (D1), wherein a crossing (C) of the conductor (210) with itself is present between the first loop (L1) and the second loop (L2), wherein the first loop (L1) and the second loop (L2) define a first enclosed area (A1) and a second enclosed area (A2), respectively;
**characterized by**:
at least one ground bar (GB1, GB2) traversing either the first loop (L1) or the second loop (L2);
wherein the inductor (IN) is at least partially surrounded by a ground ring (GR); and
wherein the at least one ground bar (GB1, GB2) traversing either the first loop (L1) or the second loop (L2) extends along a second direction (D2) that is orthogonal to the first direction (D1), is not electrically connected to the conductor (210), and is electrically connected to the ground ring.

2. The semiconductor device (1a; 1b; 1c) according to claim 1, wherein the at least one ground bar (GB1, GB2) traversing either the first loop (L1) or the second loop (L2) comprises a first ground bar (GB1) traversing the first loop (L1) and a second ground bar (GB2) traversing the second loop (L2), and wherein the first ground bar (GB1) and the second ground bar (GB2) extend along the second direction (D2) that is orthogonal to the first direction (D1), are not electrically connected to the conductor (210), and are electrically connected to the ground ring (GR).

3. The semiconductor device (1a; 1b; 1c) according to claim 1 or 2, wherein the ground ring (GR) is constructed at a top metal layer (202) over the substrate (100).

4. The semiconductor device (1a; 1b; 1c) according to any one of claims 1 to 3, wherein the at least one ground bar (GB1, GB2) traversing either the first loop (L1) or the second loop (L2) passes through a center of either the first loop (L1) or the second loop (L2);
wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the first ground bar (GB1) passes through a center of the first loop (L1) and the second ground bar (GB2) passes through a center of the second loop (L2).

5. The semiconductor device (1a; 1b; 1c) according to any one of claims 1 to 4, wherein the at least one ground bar (GB1, GB2) traversing either the first loop (L1) or the second loop (L2) is fabricated with a minimum design rule;
wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the first ground bar (GB1) and the second ground bar (GB2) are fabricated with a minimum design rule.

6. The semiconductor device (1a; 1b; 1c) according to any one of claims 1 to 5, wherein the at least one ground bar (GB1, GB2) traversing either the first loop (L1) or the second loop (L2) has a line width substantially smaller than or equal to loop size of the first loop (L1) or the second loop (L2);
wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the first ground bar (GB1) has a line width substantially smaller than or equal to loop size of the first loop (L1) and the second ground bar (GB2) has a line width substantially smaller than or equal to loop size of the second loop (L2).

7. The semiconductor device (1a; 1b; 1c) according to any one of claims 1 to 6, wherein the first enclosed area (A1) is smaller than the second enclosed area (A2).

8. The semiconductor device (1b) according to any one of claims 1 to 7 further comprising:
at least one ground bar (GB3) not traversing the first loop (L1) and the second loop (L2);
wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the at least one ground bar (GB3) not traversing the first loop (L1) and the second loop (L2) comprises a third ground bar (GB3) interposed between the first ground bar (GB1) and the second ground bar (GB2).

9. The semiconductor device (1b) according to claim 8, wherein the at least one ground bar (GB3) not traversing the first loop (L1) and the second loop (L2) overlaps with the crossing (C);
wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the third ground bar (GB3) overlaps with the crossing (C).

## Patentansprüche

1. Halbleitervorrichtung (1a; 1b; 1c), umfassend:
ein Substrat (100);
einen ersten Anschluss (A) und einen zweiten Anschluss (B);
einen Leiter (210), der auf dem Substrat (100) zwischen dem ersten Anschluss (A) und dem zweiten Anschluss (B) angeordnet ist, um eine Induktivität (IN) zu bilden, der zum Bilden einer ersten Schleife (L1) und einer zweiten Schleife (L2) geformt ist, die nebeneinander entlang einer ersten Richtung (D1) angeordnet sind, wobei eine Kreuzung (C) des Leiters (210) mit sich selbst zwischen der ersten Schleife (L1) und der zweiten Schleife (L2) vorhanden ist, wobei die erste Schleife (L1) und die zweite Schleife (L2) einen ersten umschlossenen Bereich (A1) bzw. einen zweiten umschlossenen Bereich (A2) definieren;
**gekennzeichnet durch**:
mindestens eine Masseschiene (GB1, GB2), die entweder die erste Schleife (L1) oder die zweite Schleife (L2) durchquert;
wobei die Induktivität (IN) mindestens teilweise von einem Massering (GR) umgeben ist; und
wobei die mindestens eine Masseschiene (GB1, GB2), die entweder die erste Schleife (L1) oder die zweite Schleife (L2) durchquert, sich entlang einer zweiten Richtung (D2) erstreckt, die orthogonal zur ersten Richtung (D1) ist, nicht elektrisch mit dem Leiter (210) verbunden ist und elektrisch mit dem Massering verbunden ist.

2. Halbleitervorrichtung (1a; 1b; 1c) nach Anspruch 1, wobei die mindestens eine Masseschiene (GB1, GB2), die entweder die erste Schleife (L1) oder die zweite Schleife (L2) durchquert, eine erste Masseschiene (GB1), die die erste Schleife (L1) durchquert, und eine zweite Masseschiene (GB2), die die zweite Schleife (L2) durchquert, umfasst, und wobei die erste Masseschiene (GB1) und die zweite Masseschiene (GB2) sich entlang der zweiten Richtung (D2) erstrecken, die orthogonal zur ersten Richtung (D1) ist, nicht elektrisch mit dem Leiter (210) verbunden sind und elektrisch mit dem Massering (GR) verbunden sind.

3. Halbleitervorrichtung (1a; 1b; 1c) nach Anspruch 1 oder 2, wobei der Massering (GR) an einer oberen Metallschicht (202) über dem Substrat (100) aufgebaut ist.

4. Halbleitervorrichtung (1a; 1b; 1c) nach einem der Ansprüche 1 bis 3, wobei die mindestens eine Masseschiene (GB1, GB2), die entweder die erste Schleife (L1) oder die zweite Schleife (L2) durchquert, durch eine Mitte entweder der ersten Schleife (L1) oder der zweiten Schleife (L2) verläuft;
wobei für den Fall, dass die mindestens eine Masseschiene (GB1, GB2), die entweder die erste Schleife (L1) oder die zweite Schleife (L2) durchquert, die erste Masseschiene (GB1), die die erste Schleife (L1) durchquert, und die zweite Masseschiene (GB2), die die zweite Schleife (L2) durchquert, umfasst, die erste Masseschiene (GB1) durch eine Mitte der ersten Schleife (L1) verläuft und die zweite Masseschiene (GB2) durch eine Mitte der zweiten Schleife (L2) verläuft.

5. Halbleitervorrichtung (1a; 1b; 1c) nach einem der Ansprüche 1 bis 4, wobei die mindestens eine Masseschiene (GB1, GB2), die entweder die erste Schleife (L1) oder die zweite Schleife (L2) durchquert, mit einer Minimaldesignregel hergestellt ist;
wobei für den Fall, dass die mindestens eine Masseschiene (GB1, GB2), die entweder die erste Schleife (L1) oder die zweite Schleife (L2) durchquert, die erste Masseschiene (GB1), die die erste Schleife (L1) durchquert, und die zweite Masseschiene (GB2), die die zweite Schleife (L2) durchquert, umfasst, die erste Masseschiene (GB1) und die zweite Masseschiene (GB2) mit einer Minimaldesignregel hergestellt sind.

6. Halbleitervorrichtung (1a; 1b; 1c) nach einem der Ansprüche 1 bis 5, wobei die mindestens eine Masseschiene (GB1, GB2), die entweder die erste Schleife (L1) oder die zweite Schleife (L2) durchquert, eine Linienbreite aufweist, die im Wesentlichen kleiner oder gleich der Schleifengröße der ersten Schleife (L1) oder der zweiten Schleife (L2) ist;
wobei für den Fall, dass die mindestens eine Masseschiene (GB1, GB2), die entweder die erste Schleife (L1) oder die zweite Schleife (L2) durchquert, die erste Masseschiene (GB1), die die erste Schleife (L1) durchquert, und die zweite Masseschiene (GB2), die die zweite Schleife (L2) durchquert, umfasst, die erste Masseschiene (GB1) eine Linienbreite aufweist, die im Wesentlichen kleiner oder gleich der Schleifengröße der ersten Schleife (L1) ist, und die zweite Masseschiene (GB2) eine Linienbreite aufweist, die im Wesentlichen kleiner oder gleich der Schleifengröße der zweiten Schleife (L2) ist.

7. Halbleitervorrichtung (1a; 1b; 1c) nach einem der Ansprüche 1 bis 6, wobei der erste umschlossene Bereich (A1) kleiner als der zweite umschlossene Bereich (A2) ist.

8. Halbleitervorrichtung (1b) nach einem der Ansprüche 1 bis 7, ferner umfassend:
mindestens eine Masseschiene (GB3), die nicht die erste Schleife (L1) und die zweite Schleife (L2) durchquert;
wobei für den Fall, dass die mindestens eine Masseschiene (GB1, GB2), die entweder die erste Schleife (L1) oder die zweite Schleife (L2) durchquert, die erste Masseschiene (GB1), die die erste Schleife (L1) durchquert, und die zweite Masseschiene (GB2), die die zweite Schleife (L2) durchquert, umfasst, die mindestens eine Masseschiene (GB3), die nicht die erste Schleife (L1) und die zweite Schleife (L2) durchquert, eine dritte Masseschiene (GB3) umfasst, die zwischen der ersten Masseschiene (GB1) und der zweiten Masseschiene (GB2) angeordnet ist.

9. Halbleitervorrichtung (1b) nach Anspruch 8, wobei die mindestens eine Masseschiene (GB3), die nicht die erste Schleife (L1) und die zweite Schleife (L2) durchquert, mit der Kreuzung (C) überlappt;
wobei für den Fall, dass die mindestens eine Masseschiene (GB1, GB2), die entweder die erste Schleife (L1) oder die zweite Schleife (L2) durchquert, die erste Masseschiene (GB1), die die erste Schleife (L1) durchquert, und die zweite Masseschiene (GB2), die die zweite Schleife (L2) durchquert, umfasst, die dritte Masseschiene (GB3) mit der Kreuzung (C) überlappt.

## Revendications

1. Dispositif semi-conducteur (1a ; 1b ; 1c), comprenant :
un substrat (100) ;
une première borne (A) et une seconde borne (B) ;
un conducteur (210) agencé sur le substrat (100) entre la première borne (A) et la seconde borne (B) pour constituer un inducteur (IN) formée pour former une première boucle (L1) et une seconde boucle (L2) agencées côte à côte le long d'une première direction (D1), dans lequel un croisement (C) du conducteur (210) avec lui-même est présent entre la première boucle (L1) et la seconde boucle (L2), dans lequel la première boucle (L1) et la seconde boucle (L2) définissent une première zone fermée (A1) et une seconde zone fermée (A2), respectivement ;
**caractérisé par** :
au moins une barre de masse (GB1, GB2) traversant soit la première boucle (L1) soit la seconde boucle (L2) ;
dans lequel l'inducteur (IN) est au moins partiellement entouré par un anneau de masse (GR) ; et
dans lequel l'au moins une barre de masse (GB1, GB2) traversant soit la première boucle (L1) soit la seconde boucle (L2) s'étend le long d'une seconde direction (D2) qui est orthogonale à la première direction (D1), n'est pas connectée électriquement au conducteur (210), et est connectée électriquement à l'anneau de masse.

2. Dispositif semi-conducteur (1a ; 1b ; 1c) selon la revendication 1, dans lequel l'au moins une barre de masse (GB1, GB2) traversant soit la première boucle (L1) soit la seconde boucle (L2) comprend une première barre de masse (GB1) traversant la première boucle (L1) et une seconde barre de masse (GB2) traversant la seconde boucle (L2), et dans lequel la première barre de masse (GB1) et la seconde barre de masse (GB2) s'étendent le long de la seconde direction (D2) qui est orthogonale à la première direction (D1), ne sont pas connectées électriquement au conducteur (210), et sont connectées électriquement à l'anneau de masse (GR).

3. Dispositif semi-conducteur (1a ; 1b ; 1c) selon la revendication 1 ou 2, dans lequel l'anneau de masse (GR) est construit au niveau d'une couche métallique supérieure (202) sur le substrat (100).

4. Dispositif semi-conducteur (1a ; 1b ; 1c) selon l'une quelconque des revendications 1 à 3, dans lequel l'au moins une barre de masse (GB1, GB2) traversant soit la première boucle (L1) soit la seconde boucle (L2) passe à travers un centre de soit la première boucle (L1) soit la seconde boucle (L2) ;
dans lequel pour le cas où l'au moins une barre de masse (GB1, GB2) traversant soit la première boucle (L1) soit la seconde boucle (L2) comprend la première barre de masse (GB1) traversant la première boucle (L1) et la seconde barre de masse (GB2) traversant la seconde boucle (L2), la première barre de masse (GB1) passe à travers un centre de la première boucle (L1) et la seconde barre de masse (GB2) passe à travers un centre de la seconde boucle (L2).

5. Dispositif semi-conducteur (1a ; 1b ; 1c) selon l'une quelconque des revendications 1 à 4, dans lequel l'au moins une barre de masse (GB1, GB2) traversant soit la première boucle (L1) soit la seconde boucle (L2) est fabriquée avec une règle de conception minimale ;
dans lequel pour le cas où l'au moins une barre de masse (GB1, GB2) traversant soit la première boucle (L1) soit la seconde boucle (L2) comprend la première barre de masse (GB1) traversant la première boucle (L1) et la seconde barre de masse (GB2) traversant la seconde boucle (L2), la première barre de masse (GB1) et la seconde barre de masse (GB2) sont fabriquées avec une règle de conception minimale.

6. Dispositif semi-conducteur (1a ; 1b ; 1c) selon l'une quelconque des revendications 1 à 5, dans lequel l'au moins une barre de masse (GB1, GB2) traversant soit la première boucle (L1) soit la seconde boucle (L2) a une largeur de ligne sensiblement inférieure ou égale à une taille de boucle de la première boucle (L1) ou de la seconde boucle (L2) ;
dans lequel pour le cas où l'au moins une barre de masse (GB1, GB2) traversant soit la première boucle (L1) soit la seconde boucle (L2) comprend la première barre de masse (GB1) traversant la première boucle (L1) et la seconde barre de masse (GB2) traversant la seconde boucle (L2), la première barre de masse (GB1) a une largeur de ligne sensiblement inférieure ou égale à une taille de boucle de la première boucle (L1) et la seconde barre de masse (GB2) a une largeur de ligne sensiblement inférieure ou égale à une taille de boucle de la seconde boucle (L2).

7. Dispositif semi-conducteur (1a ; 1b ; 1c) selon l'une quelconque des revendications 1 à 6, dans lequel la première zone enfermée (A1) est plus petite que la seconde zone enfermée (A2).

8. Dispositif semi-conducteur (1b) selon l'une quelconque des revendications 1 à 7, comprenant en outre :
au moins une barre de masse (GB3) ne traversant pas la première boucle (L1) et la seconde boucle (L2) ;
dans lequel pour le cas où l'au moins une barre de masse (GB1, GB2) traversant soit la première boucle (L1) soit la seconde boucle (L2) comprend la première barre de masse (GB1) traversant la première boucle (L1) et la seconde barre de masse (GB2) traversant la seconde boucle (L2), l'au moins une barre de masse (GB3) ne traversant pas la première boucle (L1) et la seconde boucle (L2) comprend une troisième barre de masse (GB3) interposée entre la première barre de masse (GB1) et la seconde barre de masse (GB2).

9. Dispositif semi-conducteur (1b) selon la revendication 8, dans lequel l'au moins une barre de masse (GB3) ne traversant pas la première boucle (L1) et la seconde boucle (L2) chevauche le croisement (C) ;
dans lequel pour le cas où l'au moins une barre de masse (GB1, GB2) traversant soit la première boucle (L1) soit la seconde boucle (L2) comprend la première barre de masse (GB1) traversant la première boucle (L1) et la seconde barre de masse (GB2) traversant la seconde boucle (L2), la troisième barre de masse (GB3) chevauche le croisement (C).
